(19) **Europäisches Patentamt / European Patent Office / Office européen des brevets**

(11) **EP 3 834 229 B1**

(12) **FASCICULE DE BREVET EUROPEEN**

(45) Date de publication et mention de la délivrance du brevet:
**28.09.2022 Bulletin 2022/39**

(21) Numéro de dépôt: **19749738.1**

(22) Date de dépôt: **08.08.2019**

(51) Classification Internationale des Brevets (IPC):
*H01L 23/525* (2006.01)    *H01L 29/778* (2006.01)
*H01L 23/62* (2006.01)    *H01L 29/417* (2006.01)
*H01L 29/20* (2006.01)    *H01L 29/423* (2006.01)

(52) Classification Coopérative des Brevets (CPC):
**H01L 23/5256; H01L 29/41758; H01L 29/7786;**
H01L 23/62; H01L 29/2003; H01L 29/41766;
H01L 29/4236

(86) Numéro de dépôt international:
**PCT/EP2019/071361**

(87) Numéro de publication internationale:
**WO 2020/030757 (13.02.2020 Gazette 2020/07)**

(54) **TRANSISTOR À EFFET DE CHAMP ET PROCÉDÉ DE FABRICATION ASSOCIÉ**

FELDEFFEKTTRANSISTOR UND ZUGEHÖRIGES HERSTELLUNGSVERFAHREN

FIELD-EFFECT TRANSISTOR AND ASSOCIATED MANUFACTURING METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.08.2018 FR 1857444**

(43) Date de publication de la demande:
**16.06.2021 Bulletin 2021/24**

(73) Titulaire: **Commissariat à l'Energie Atomique et aux Energies Alternatives**
**75015 Paris (FR)**

(72) Inventeurs:
• **BUCKLEY, Julien**
**38054 GRENOBLE CEDEX 9 (FR)**
• **ESCOFFIER, René**
**38054 GRENOBLE CEDEX 9 (FR)**

(74) Mandataire: **Cabinet Camus Lebkiri**
**25 rue de Maubeuge**
**75009 Paris (FR)**

(56) Documents cités:
| | |
|---|---|
| EP-A2- 2 690 657 | WO-A1-2010/013195 |
| JP-A- 2004 235 183 | JP-A- 2017 204 653 |
| KR-A- 20110 035 406 | US-A- 4 742 425 |
| US-A- 4 795 720 | US-A- 4 942 308 |
| US-A1- 2009 026 506 | US-A1- 2011 001 736 |
| US-A1- 2011 186 858 | |

**Description**

**DOMAINE TECHNIQUE DE L'INVENTION**

La présente invention concerne les transistors à effets de champ, et plus particulièrement les transistors comprenant plusieurs transistors élémentaires connectés en parallèle.

**ARRIÈRE-PLAN TECHNOLOGIQUE DE L'INVENTION**

Les transistors de puissance sont destinés à être traversés par des courants électriques de forte intensité, c'est-à-dire des courants de plusieurs dizaines d'ampères. Les transistors de puissance présentent donc des dimensions importantes, compatibles avec ces niveaux de courant.

Classiquement, de tels transistors de grandes dimensions sont réalisés en connectant en parallèle plusieurs transistors élémentaires, appelés « îlots », ayant des dimensions plus petites. Cependant, au cours de la fabrication d'un transistor, il peut arriver qu'un court-circuit apparaisse au niveau de certains îlots, ce qui rend inutilisable l'ensemble du transistor.

Pour remédier à cet inconvénient, il est connu de l'art antérieur une méthode pour isoler électriquement les îlots défectueux des îlots fonctionnels. Cette méthode consiste à tester un par un les îlots pour rechercher ceux présentant un court-circuit. Ces derniers sont alors isolés au moyen d'une couche d'un matériau polymère qui est déposée sur l'ensemble des îlots et qui est ensuite gravée pour laisser accessible à la métallisation uniquement les îlots fonctionnels. Le problème de cette méthode est que sa mise en œuvre nécessite beaucoup de temps.

Le document EP2690657 décrit un transistor à effet de champ, par exemple de type GaN HEMT, comprenant un substrat, une hétérojonction formée sur le substrat, une électrode de grille, une électrode de drain et une électrode de source à doigts interdigités, une première piste de connexion reliant électriquement les doigts de l'électrode de drain entre eux et une deuxième piste de connexion reliant électriquement les doigts de l'électrode de source entre eux. Chaque doigt de l'électrode de drain est relié à la première piste de connexion par l'intermédiaire d'un fusible. Les fusibles sont aptes à être rompus, lors du fonctionnement du transistor, pour isoler électriquement des doigts de drain défectueux (par exemple en court-circuit avec l'électrode grille), tandis que les autres doigts de drain restent opérationnels.

Un inconvénient de ce transistor est que, malgré la rupture des fusibles, des courants de fuite peuvent circuler dans les doigts de drain défectueux. En effet, d'après le document [« Electrical Breakdown in Atmospheric Air Between Closely Spaced (0.2$\mu$m-40$\mu$m) Electrical Contacts », P.G. Slade et al., IEEE Transactions On Components And Packaging Technologies, Vol. 25, N°3, 2002], la tension de claquage ne dépasse pas 450 V pour un espace entre deux électrodes inférieur ou égal à 25 $\mu$m.

**RÉSUMÉ DE L'INVENTION**

La présente invention vise à résoudre le problème qui vient d'être mentionné. À cette fin, un premier aspect de l'invention concerne un transistor à effet de champ comportant :

- un substrat ;
- une structure semi-conductrice formée sur une face principale du substrat, la structure semi-conductrice comprenant une zone de canal ;
- une première électrode et une deuxième électrode entre lesquelles s'étend la zone de canal, la première électrode comportant une pluralité de portions espacées les unes des autres, chaque portion de la première électrode contribuant à former un transistor élémentaire appelé « îlot » ;
- des pistes de connexion pour connecter électriquement les portions de la première électrode entre elles ;
- des premières zones fusibles connectant chacune une portion associée de la première électrode à une piste de connexion ;
- au moins une deuxième zone fusible rompue de manière à isoler électriquement une portion associée de la première électrode appartenant à un îlot défectueux ;
- une couche de passivation disposée sur les îlots, les pistes de connexion et les zones fusibles, la couche de passivation occupant chaque espace créé par la rupture de ladite au moins une deuxième zone fusible.

Le transistor à effet de champ selon le premier aspect de l'invention peut également comporter une ou plusieurs caractéristiques parmi les suivantes considérées individuellement ou selon toutes les combinaisons techniquement possibles.

Selon un mode de réalisation, les zones fusibles s'étendent selon une direction longitudinale.

Selon un mode de réalisation, chaque îlot présente un courant de fonctionnement maximal, les zones fusibles étant dimensionnées de manière à supporter le courant maximal de fonctionnement.

Selon un mode de réalisation, la deuxième électrode comporte également une pluralité de portions espacées les unes des autres, les portions de la première électrode et de la deuxième électrode étant disposées de manière alternée pour former un motif de type damier.

Selon un mode de réalisation, les zones fusibles sont réalisées dans le même matériau que les pistes de connexion.

Selon un mode de réalisation, les zones fusibles sont en cuivre, en aluminium ou en tungstène.

Un deuxième aspect de l'invention concerne un procédé de fabrication d'un transistor à effet de champ. Ce procédé de fabrication comporte les étapes suivantes :

- former une structure semi-conductrice sur une face principale d'un substrat, la structure semi-conductrice comprenant une zone de canal ;

- former une première électrode et une deuxième électrode entre lesquelles s'étend la zone de canal, la première électrode comportant une pluralité de portions espacées les unes des autres, chaque portion de la première électrode contribuant à former un transistor élémentaire appelé « îlot » ;

- former des pistes de connexion pour connecter électriquement les portions de la première électrode entre elles ;

- former des zones fusibles associées chacune à une portion de la première électrode d'un îlot, chaque zone fusible connectant la portion associée de la première électrode à une piste de connexion et étant apte à être rompue de manière à isoler électriquement ledit îlot s'il est défectueux ;

- rompre chaque zone fusible associée à la portion de la première électrode d'un îlot défectueux ;

- déposer une couche de passivation sur les îlots, les pistes de connexion et les zones fusibles, la couche de passivation occupant chaque espace créé par la rupture d'une zone fusible.

L'utilisation de zones fusibles permet d'isoler électriquement tous les îlots défectueux au cours d'une seule étape du procédé de fabrication, ce qui représente un gain de temps considérable.

Le procédé de fabrication selon le deuxième aspect de l'invention peut également comporter une ou plusieurs caractéristiques parmi les suivantes considérées individuellement ou selon toutes les combinaisons techniquement possibles.

Selon un mode de mise en œuvre, l'étape de rupture consiste à appliquer un courant d'intensité croissante entre la première électrode et la deuxième électrode.

Selon un mode de mise en œuvre, l'étape de rupture consiste à appliquer une rampe de courant entre la première électrode et la deuxième électrode.

Selon un mode de mise en œuvre, la rampe de courant est assortie d'une limitation en tension.

Selon un mode de mise en œuvre, le procédé de fabrication comporte, entre l'étape de rupture et l'étape de dépôt de la couche de passivation, une étape de nettoyage destinée à éliminer des résidus résultant de l'étape de rupture.

Selon un mode de mise en œuvre, le procédé de fabrication comporte une étape de vérification que chaque zone fusible associée à la portion de la première électrode d'un îlot défectueux est effectivement rompue.

## BRÈVE DESCRIPTION DES FIGURES

L'invention et ses différentes applications seront mieux comprises à la lecture de la description qui suit et à l'examen des figures qui l'accompagnent, parmi lesquelles :

- la figure 1A est une vue de dessus d'un transistor, selon un premier mode de réalisation de l'invention ;
- la figure 1B est une vue agrandie d'une zone fusible du transistor de la figure 1A
- la figure 1C est une vue en coupe transversale selon la ligne A-A du transistor de la figure 1A ;
- la figure 2 représente des courbes de variation du temps de claquage d'une zone fusible en fonction de l'intensité du courant électrique traversant la zone fusible, chaque courbe correspondant à un matériau différent avec lequel la zone fusible est réalisée ;
- la figure 3 est une vue de dessus d'un transistor, selon un deuxième mode de réalisation de l'invention ;
- la figure 4 représente des courbes de variation de la tension en fonction du courant dans une structure de test comportant une zone fusible ;

- la figure 5 représente une courbe de variation du courant de fuite en fonction de la tension dans la structure de test de la figure 4, lorsque la zone fusible est rompue.

Les figures sont schématiques et ne respectent pas les proportions entre les différents éléments représentés, ceci afin d'en faciliter la lecture.

Les figures ne sont présentées qu'à titre indicatif et nullement limitatif de l'invention.

Pour plus de clarté, les éléments identiques ou similaires sont repérés par des signes de référence identiques sur toutes les figures.

**DESCRIPTION DÉTAILLÉE DE MODES DE MISE EN ŒUVRE DE L'INVENTION**

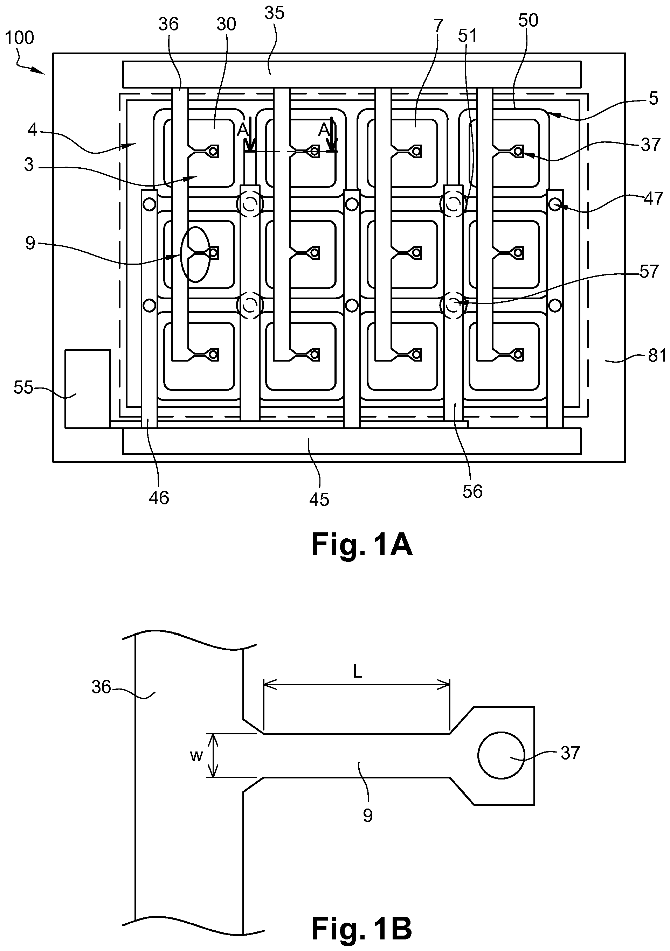

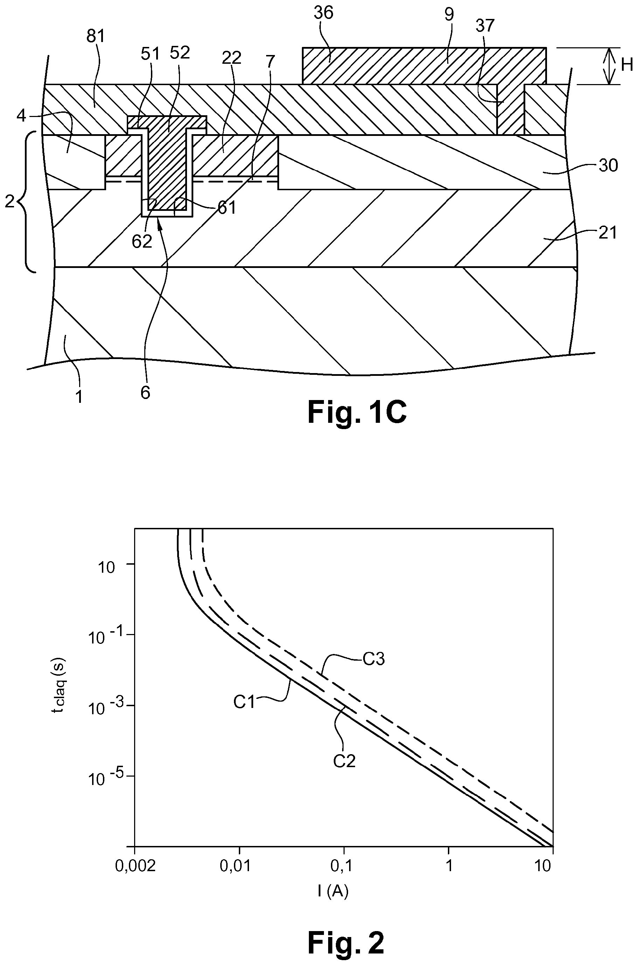

Un premier mode de réalisation d'un transistor à effet de champ 100 selon l'invention va maintenant être décrit en référence aux figures 1A, 1B et 1C. Le transistor 100 est par exemple un transistor à hétérojonction à haute mobilité électronique, également appelé HEMT pour « High Electron Mobility Transistor » selon la terminologie anglo-saxonne. Un tel transistor 100 est généralement destiné à des applications de puissance. Toutefois, la présente invention peut bien entendu être appliquée à d'autres types de transistors.

Le transistor 100 comporte un substrat 1 et une structure semi-conductrice 2 formée sur le substrat 1. La structure semi-conductrice 2 comporte par exemple une première couche semi-conductrice 21 disposée sur le substrat 1 et une deuxième couche semi-conductrice 22 disposée sur la première couche semi-conductrice 21. La première couche semi-conductrice 21 et la deuxième couche semi-conductrice 22 sont par exemple respectivement en nitrure de gallium (GaN) et en nitrure d'aluminium-gallium (AlGaN). Dans ce cas, un gaz d'électrons est intrinsèquement formé par hétérojonction à l'interface entre la première couche semi-conductrice 21 et la deuxième couche semi-conductrice 22.

Le substrat 1 peut être un isolant ou un semi-conducteur tel que du silicium intrinsèque ou dopé. Avantageusement, le substrat 1 est du silicium à orientation de maille cristalline selon la direction <111> ce qui permet de faciliter la croissance du nitrure de gallium à sa surface. Le substrat 1 peut également être du carbure de silicium, du nitrure de galium ou du saphir.

Le transistor 100 comporte une électrode de drain 3 et une électrode de source 4 formées sur la structure semi-conductrice 2. L'électrode de drain 3 et l'électrode de source 4 sont par exemple en métal tel que du titane ou de l'aluminium.

Dans ce premier mode de réalisation, l'électrode de drain 3 présente une topologie en îlots, c'est-à-dire qu'elle comporte plusieurs portions de drain 30 espacées les unes des autres. Les portions de drain 30 sont ici entourées par l'électrode de source 4. Par extension, on dit que le transistor 100 présente une topologie en îlots. De manière générale, un transistor présente une topologie en îlots lorsque son électrode de drain et/ou son électrode de source présentent une topologie en îlots.

Chaque portion de drain 30 contribue à la formation d'un transistor élémentaire, le transistor 100 résultant de la mise en parallèle de ces transistors élémentaires. Dans la suite de la description, le terme « îlot » peut être utilisé pour désigner indifféremment une portion de drain 30 ou le transistor élémentaire auquel appartient cette portion de drain 30.

Le transistor 100 comporte également une électrode de grille 5 disposée entre l'électrode de drain 3 et l'électrode de source 4. L'électrode de grille comporte par exemple plusieurs portions de grille 50 entourant chacune une portion de drain 30. Chaque portion de grille 50 est par exemple disposée dans une cavité 6 formée à travers la deuxième couche semi-conductrice 22. La cavité 6 s'étend dans la première couche semi-conductrice 21. Toutefois, la cavité 6 ne traverse pas complètement la première couche semi-conductrice 21. La cavité 6 comporte donc un fond 61 formé par la première couche semi-conductrice 21 et des parois latérales 62 formées par l'empilement de la première couche semi-conductrice 21 et de la deuxième couche semi-conductrice 22.

L'électrode de grille 5 comporte une couche d'isolant de grille 51 recouvrant le fond 61 et les parois latérales 62 de la cavité 6. L'électrode de grille 5 comporte ici un débordement latéral de part et d'autre de la cavité 6. Autrement dit, la couche d'isolant de grille 51 s'étend en dehors de la cavité 6 sur la deuxième couche semi-conductrice 22. La couche d'isolant de grille 51 est par exemple réalisée en oxyde d'aluminium. Toutefois, d'autres matériaux isolants connus de l'industrie microélectronique peuvent convenir à la formation de la couche d'isolant de grille 51.

L'électrode de grille 5 comporte également un matériau de grille 52 conducteur électriquement disposé dans la cavité 6, dans un espace non occupé par la couche d'isolant de grille 51. Le matériau de grille 52 est séparé des couches semiconductrices 21, 22 par la couche d'isolant de grille 51. Le matériau de grille 52 est en contact avec la couche d'isolant de grille 51. Le matériau de grille 52 peut également déborder de la cavité 6 sans jamais entrer en contact avec les couches semiconductrices 21, 22. Le matériau de grille 52 est par exemple du métal tel que du nitrure de titane, du tungstène ou du nickel.

Le transistor 100 comporte une zone de canal 7 s'étendant entre l'électrode de drain 3 et l'électrode de source 4 et dans laquelle la conduction est commandée par l'électrode de grille 5. La zone de canal 7 correspond ici au gaz d'électrons présent à l'interface entre la première couche semi-conductrice 21 et la deuxième couche semi-conductrice 22. La topologie en îlots permet d'augmenter la densité de la zone de canal 7 par rapport à des géométries interdigitées classiques. L'avantage de la topologie en îlots est qu'elle permet d'isoler les zones défectueuses le cas échéant. Il est cependant également possible de réaliser des îlots interdigités.

Le transistor 100 est par exemple de type normalement bloqué (« normally-off » selon la terminologie anglo-saxonne), c'est-à-dire qu'en l'absence de polarisation, le transistor 100 est bloqué. Pour rendre le transistor 100 passant, il faut accumuler suffisamment d'électrons dans la zone de canal 7 sous l'électrode de grille 5. Pour ce faire, il faut appliquer une différence de potentiel entre l'électrode de source 4 et l'électrode de grille 5 supérieure à une tension de seuil positive.

Le transistor 100 comporte un premier plot 35, un deuxième plot 45 et un troisième plot 55 prévus pour réaliser respectivement le contact de drain, le contact de source et le contact de grille.

Les portions de drain 30 sont connectées électriquement au premier plot 35 par l'intermédiaire de premières pistes de connexions 36 et de premiers vias d'interconnexion 37. Un premier via d'interconnexions 37 est par exemple disposé sur chaque portion de drain 30.

L'électrode de source 4 est connectée électriquement au deuxième plot 45 par l'intermédiaire de deuxièmes pistes de connexion 46 et de deuxièmes vias de d'interconnexion 47 répartis sur l'électrode de source 4. Ainsi, bien que dans ce mode de réalisation l'électrode de source 4 soit continue, la résistance d'accès à l'électrode de source 4 est réduite.

Avantageusement, le transistor 100 comporte des zones de grille 53 configurées pour connecter électriquement des portions de grille 50 adjacentes. Par exemple, chaque zone de grille 53 connecte électriquement quatre portions de grille 50 disposées en carré.

Les portions de grille 50 sont connectées électriquement au troisième plot 55 par l'intermédiaire de troisièmes pistes de connexions 56 et de troisièmes vias d'interconnexion 57. Un troisième via d'interconnexions 57 est par exemple disposé sur chaque zone de grille 53 de l'électrode de grille 5.

Les pistes de connexions 36, 46, 56 sont chacune réalisées dans un matériau conducteur électriquement. Les pistes de connexions 36, 46, 56 sont de préférence en métal tel que du cuivre, de l'aluminium ou alliage AlCu.

Le transistor 100 comporte une première couche de passivation 81 qui recouvre la structure semi-conductrice 2 et les électrodes de drain 3, de source 4 et grille 5. La première couche de passivation 81 est par exemple en oxyde de silicium ou en nitrure de silicium. Les vias d'interconnexion 37, 47, 57 sont formés à travers la première couche de passivation 81.

Chaque portion de drain 30 est connectée à l'une des premières pistes de connexion 36 par l'intermédiaire d'une zone fusible 9. Les zones fusibles 9 associées à des îlots défectueux sont rompues au cours de la fabrication du transistor 100, comme décrit plus en détail par la suite. Ainsi, grâce à l'invention, il est possible de connecter uniquement les îlots fonctionnels.

Dans le contexte de l'invention, on entend par « îlots défectueux » des îlots (ou transistors élémentaires) qui sont en court-circuit, c'est-à-dire des îlots pour lesquels il existe un chemin de passage du courant électrique entre l'électrode de drain 3 et l'électrode de source 4. Dans le cas par exemple du transistor 100 qui est du type normalement bloqué, on considère que lorsque la grille n'est pas polarisée et que le transistor 100 est passant, c'est qu'il comporte au moins un îlot défectueux.

La zone fusible 9 est réalisée dans un matériau fusible conducteur électriquement, de préférence identique à celui utilisé pour réaliser les premières pistes de connexion 36. La zone fusible 9 est par exemple disposée sur la première couche de passivation 81, entre le premier via d'interconnexion 37 et la première piste de connexion 36 correspondante.

Avantageusement, la zone fusible 9 s'étend selon une direction longitudinale, c'est-à-dire selon une direction sensiblement parallèle au plan dans lequel s'étend le substrat 1. Ainsi, lorsque la zone fusible 9 se rompt, le matériau fusible a la possibilité de s'étendre. Dans ce cas, la zone fusible 9 n'est pas confinée, contrairement par exemple au cas d'une orientation transversale réalisée au moyen d'un via. Autrement dit, l'orientation longitudinale de la zone fusible 9 permet de faciliter l'évacuation du matériau fusible lors du claquage afin que la zone fusible 9 ne forme plus de chemin conducteur électriquement.

La zone fusible 9 a par exemple une forme générale parallélépipédique présentant une longueur L, une largeur W et une hauteur H. Par ailleurs, chaque îlot du transistor 100 est conçu pour avoir un certain calibre en courant. Avantageusement, la zone fusible 9 est dimensionnée de manière à être compatible avec le calibre en courant des îlots du transistor 100. Ainsi, on s'assure que la zone fusible 9 ne claque pas lorsque le transistor 100 est en fonctionnement. Autrement dit, les dimensions de la zone fusible 9 lui permettent de supporter le passage du courant de fonctionnement correspondant au calibre des îlots du transistor 100.

La zone fusible 9 peut également être dimensionnée en fonction du temps avant claquage que l'on souhaite obtenir. Dans le contexte de l'invention, on entend par « temps avant claquage » le temps que met la zone fusible pour se rompre lorsqu'elle est traversée par une intensité de courant donnée.

Le temps avant claquage $t_{claq}$ est par exemple calculé en égalisant l'énergie électrique fournie à la zone fusible 9 avec la somme de l'énergie thermique absorbée par la zone fusible 9 et de l'énergie thermique évacuée par la zone fusible 9 dans l'air à la température de fusion $T_{fusion}$ du matériau fusible selon l'équation suivante :

$$\rho.\left(1 + \left(T_{fusion} - 300\right).T_{coeff}\right).\frac{L}{H.W}.I^2.t_{claq}$$
$$= C_P.L.H.W.D.\left(T_{fusion} - 300\right) + h.L.(2H + W).\left(T_{fusion} - 300\right).t_{claq} \qquad (1)$$

où p, $C_P$ et D sont respectivement la résistivité, la capacité calorifique et la densité du matériau fusible, I est le courant traversant la zone fusible 9, et h est le coefficient d'échange thermique du matériau fusible avec l'air. $T_{coeff}$ est le coefficient en température de la résistivité.

Le temps avant claquage $t_{claq}$ en fonction de l'intensité de courant I peut alors être défini par l'expression suivante :

$$t_{claq}(I) = \frac{C_P.H.W.D.\left(T_{fusion}^0 - 300\right)}{\rho.\left(1 + \left(T_{fusion}^0 - 300\right).T_{coeff}^0\right).\frac{1}{H.W}.I^2 - h.(2H + W).\left(T_{fusion}^0 - 300\right)} \qquad (2)$$

La figure 2 représente trois exemples de courbes C1, C2, C3 de variation du temps avant claquage $t_{claq}$ d'une zone fusible ayant une section carrée de 5 $\mu$m de côté en fonction de l'intensité I du courant électrique traversant la zone fusible. La première courbe C1 correspond à une zone fusible en cuivre, la deuxième courbe C2 correspond à une zone fusible en aluminium et la troisième courbe C3 correspond à une zone fusible en tungstène. L'aluminium et le cuivre sont considérés comme étant des candidats avantageux car ils sont classiquement utilisés dans l'industrie microélectronique pour réaliser des interconnexions, ce qui permet de réaliser les pistes de connexion et les zones fusibles au cours d'une même étape. Le cuivre est considéré comme étant plus avantageux que l'aluminium car le cuivre possède une tenue en courant plus élevée et une résistivité plus faible que l'aluminium.

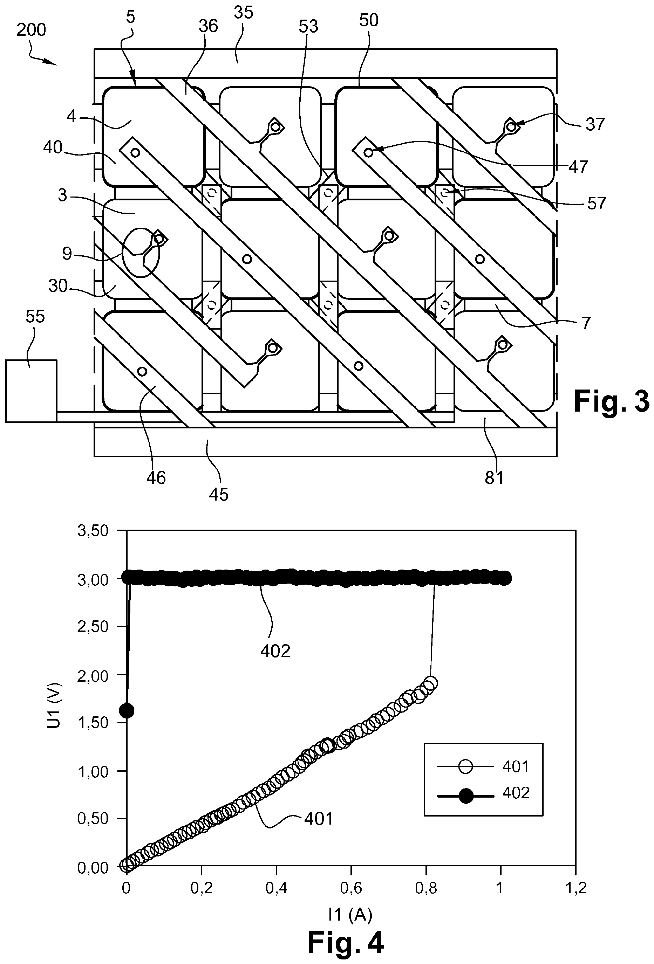

La figure 3 montre un transistor à effet de champ 200 selon un deuxième mode de réalisation de l'invention dans lequel l'électrode de source 4 présente également une topologie en îlots. L'électrode de source 4 comporte en effet plusieurs portions de source 40 espacées les unes des autres. Les portions de drain 30 et les portions de source 40 sont ici disposées de manière alternée pour former un motif de type damier.

Dans ce deuxième mode de réalisation, les portions de grille 50 entourent les portions de source 40 et sont reliées deux à deux par les zones de grille 53. Chaque zone de grille 53 est disposée entre deux portions de grille 50 adjacentes diagonalement, comme illustré à la figure 3.

Dans une variante de ce deuxième mode de réalisation, les zones fusibles peuvent être disposées entre les portions de source 40 et les deuxièmes pistes de connexion 46.

Un autre aspect de la présente invention concerne un procédé de fabrication du transistor à effet de champ selon l'un quelconque des modes de réalisation décrits ci-dessus.

Le procédé de fabrication comporte des étapes de formation de la structure semi-conductrice 2 sur le substrat 1, des électrodes de drain 3, de source 4 et de grille 5, des plots 35, 45, 55, des pistes de connexion 36, 46, 56 et des vias d'interconnexion 37, 47, 57. Ces étapes étant par ailleurs connues de l'art antérieur, elles ne seront pas décrites plus en détail dans la présente demande.

Le procédé de fabrication comporte également une étape de formation des zones fusibles 9. Chaque zone fusible 9 est formée entre une portion associée d'électrode et une piste de connexion. Comme précisé précédemment, lorsque les zones fusibles 9 sont réalisées avec le même matériau que les pistes de connexion, elles peuvent être formées au cours de la même étape.

Le procédé de fabrication comporte en outre une étape de rupture des zones fusibles 9 associées aux îlots défectueux. Pour ce faire, un courant d'intensité croissante peut être appliqué au transistor à effet de champ entre le contact de source et le contact de drain. Le courant appliqué passe principalement par les îlots défectueux ce qui provoque la rupture des zones fusibles 9 correspondantes. Ainsi, les îlots défectueux sont isolés électriquement. Il s'agit donc d'une méthode d'isolation globale, c'est-à-dire qu'elle fonctionne simultanément sur la totalité du transistor. Une telle méthode permet de gagner du temps par rapport à la méthode de l'art antérieur consistant à tester les îlots un par un pour déterminer lesquels sont défectueux.

En d'autres termes, l'étape de rupture des zones fusibles 9 permet de faire le tri, au cours de la fabrication du transistor à effet de champ, entre les îlots défectueux et les îlots fonctionnels. Les zones fusibles 9 des îlots défectueux sont rompues simultanément, tandis que les zones fusibles 9 des îlots fonctionnels restent intactes et connectent les portions d'électrode aux pistes de connexion. Une zone fusible est caractérisée par une absence de métal entre la portion associée d'électrode et la piste de connexion.

Contrairement à une simple impulsion de courant ou de tension, un courant d'intensité croissante, par exemple sous la forme d'une rampe, permet une adaptation naturelle de l'intensité de rupture au nombre de fusibles à claquer (que l'on ne connaît pas à l'avance). On s'assure ainsi que tous les fusibles des îlots défectueux ont été rompus, quel que soit le nombre de ces îlots défectueux.

Avantageusement, le courant d'intensité croissante (ex. la rampe de courant) est assorti d'une limitation en tension afin d'éviter d'endommager les îlots du transistor. Cela est particulièrement utile pour les transistors possédant un petit calibre en tension, tels que des transistors destinés à des applications audio.

La figure 4 montre un exemple de courbes de variation 401, 402 de la tension U1 aux bornes d'une structure de test en fonction du courant I1 qui traverse la structure de test. La structure de test est configurée pour modéliser le comportement d'un îlot du transistor 100. La structure de test comporte deux plots de polarisation entre lesquels est disposée une zone fusible en aluminium ayant une section carrée de 5 $\mu$m de côté. Dans cet exemple, la limitation en tension de la rampe de courant est fixée à 3 V.

La première courbe 401 correspond à l'étape de rupture de la zone fusible. Il s'agit d'une première application de la rampe de courant à la structure de test. La première courbe 401 montre que la zone fusible claque à environ 0,8 A, la tension U1 aux bornes de la structure de test étant ensuite plafonnée à la valeur limite de 3 V.

La deuxième courbe 402 correspond ici à une deuxième application de la rampe de courant I1 à la structure de test afin de s'assurer que la zone fusible s'est correctement rompue et ne s'est pas reformée. La deuxième courbe 402 montre bien que c'est le cas puisque dès le début de la rampe, la tension U1 aux bornes de la structure de test est plafonnée à 3 V.

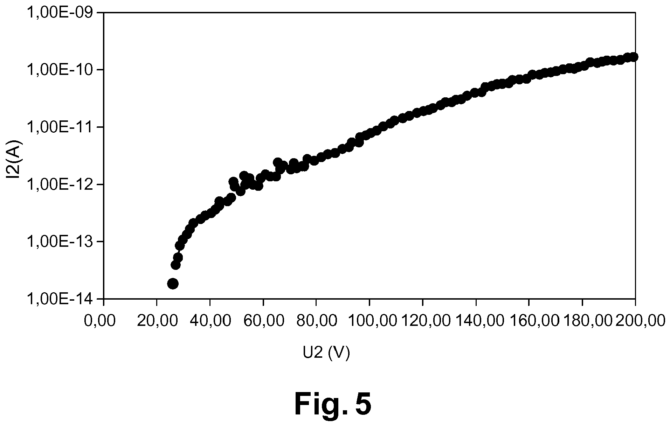

La figure 5 montre la variation du courant de fuite I2 de la structure de test en fonction de la tension de polarisation U2 appliquée à la structure de test, après que la zone fusible s'est rompue. On constate que peu importe la valeur de la tension de polarisation U2, le courant de fuite I2 reste négligeable. Cette vérification permet de mettre en évidence que la zone fusible est bien rompue.

Après l'étape de rupture des zones fusibles, le procédé de fabrication peut comporter une étape de nettoyage pour éliminer des résidus résultant du claquage des zones fusibles. Ces résidus sont susceptibles de diminuer la tenue en tension du transistor à effet de champ. L'absence de résidus dans l'espace créé par la rupture d'une zone fusible 9 réduit le risque qu'un court-circuit se forme entre la portion d'électrode déconnectée et la piste de connexion. L'étape de nettoyage comprend par exemple une première opération de nettoyage au moyen d'une solution acide destinée à éliminer des résidus métalliques. L'étape de nettoyage peut également comporter une deuxième opération de nettoyage au moyen d'une solution basique destinée à éliminer des résidus organiques.

Une deuxième couche de passivation est ensuite être déposée avant de réaliser les niveaux métalliques connectant entre elles les pistes de connexion des électrodes de source, de drain et de grille, ainsi que les couches de passivation suivantes. Cette deuxième couche de passivation est déposée sur l'ensemble des îlots (avantageusement recouverts de la première couche de passivation 81 ; cf. Fig.1A), les pistes de connexion et les zones fusibles 9. Elle occupe en outre chaque espace créé par la rupture d'une zone fusible 9, c'est-à-dire l'espace situé entre les bornes d'un fusible rompu. Autrement dit, elle est disposée au sein de chaque zone fusible 9 rompue. De cette façon, l'isolation électrique des îlots défectueux est renforcée et le risque de courants de fuite dans ces îlots est évité.

La deuxième couche de passivation comporte un matériau diélectrique, par exemple du nitrure de silicium ou de l'oxyde de silicium.

Naturellement, l'invention n'est pas limitée aux modes de mise en œuvre décrits en référence aux figures et des variantes pourraient être envisagées sans sortir du cadre de l'invention. La présente invention peut notamment être appliquée à un transistor de type normalement ouvert (« normally-on » selon la terminologie anglo-saxonne). Dans ce cas, au cours de l'étape de rupture des zones fusibles, la grille du transistor est polarisée avec une tension négative de manière à rendre le transistor bloqué.

**Revendications**

1. Transistor à effet de champ (100, 200) comportant :

   - un substrat (1) ;
   - une structure semi-conductrice (2) formée sur une face principale du substrat (1), la structure semi-conductrice (2) comprenant une zone de canal (7) ;
   - une première électrode (3) et une deuxième électrode (4) entre lesquelles s'étend la zone de canal (7), la première électrode (3) comportant une pluralité de portions (30) espacées les unes des autres, chaque portion (30) de la première électrode (3) contribuant à former un transistor élémentaire appelé « îlot » ;
   - des pistes de connexion (36) pour connecter électriquement les portions (30) de la première électrode (3) entre elles ;
- des premières zones fusibles (9) connectant chacune une portion (30) associée de la première électrode (3) à une piste de connexion (36) ;
- au moins une deuxième zone fusible rompue de manière à isoler électriquement une portion (30) associée de la première électrode (3) appartenant à un îlot défectueux ;
- une couche de passivation disposée sur les îlots, les pistes de connexion (36) et les zones fusibles (9), la couche de passivation occupant chaque espace créé par la rupture de ladite au moins une deuxième zone fusible (9).

2. Transistor (100, 200) selon la revendication 1, **caractérisé en ce que** les zones fusibles (9) s'étendent selon une direction longitudinale.

3. Transistor (100, 200) selon l'une quelconque des revendications 1 et 2, **caractérisé en ce que** chaque îlot présente un courant de fonctionnement maximal, les zones fusibles (9) étant dimensionnées de manière à supporter le courant maximal de fonctionnement.

4. Transistor (100, 200) selon l'une quelconque des revendications 1 à 3, **caractérisé en ce que** la deuxième électrode (4) comporte également une pluralité de portions (40) espacées les unes des autres, les portions (30, 40) de la première électrode (3) et de la deuxième électrode (4) étant disposées de manière alternée pour former un motif de type damier.

5. Transistor (100, 200) selon l'une quelconque des revendications 1 à 4, **caractérisé en ce que** les zones fusibles (9) sont réalisées dans le même matériau que les pistes de connexion (36).

6. Transistor (100, 200) selon l'une quelconque des revendications 1 à 5, **caractérisé en ce que** les zones fusibles (9) sont en cuivre, en aluminium ou en tungstène.

7. Procédé de fabrication d'un transistor à effet de champ (100, 200), comportant les étapes suivantes :

   - former une structure semi-conductrice (2) sur une face principale d'un substrat (1), la structure semi-conductrice (2) comprenant une zone de canal (7) ;
   - former une première électrode (3) et une deuxième électrode (4) entre lesquelles s'étend la zone de canal (7), la première électrode (3) comportant une pluralité de portions (30) espacées les unes des autres, chaque portion (30) de la première électrode (3) contribuant à former un transistor élémentaire appelé « îlot » ;
   - former des pistes de connexion (36) pour connecter électriquement les portions (30) de la première électrode (3) entre elles ;
   - former des zones fusibles (9) associées chacune à une portion (30) de la première électrode (3) d'un îlot, chaque zone fusible (9) connectant la portion (30) associée de la première électrode (3) à une piste de connexion (36) et étant apte à être rompue de manière à isoler électriquement ledit îlot s'il est défectueux ;
   - rompre chaque zone fusible (9) associée à la portion (30) de la première électrode (3) d'un îlot défectueux ;
   - déposer une couche de passivation sur les îlots, les pistes de connexion (36) et les zones fusibles (9), la couche de passivation occupant chaque espace créé par la rupture d'une zone fusible (9).

8. Procédé selon la revendication 7, **caractérisé en ce que** l'étape de rupture consiste à appliquer un courant d'intensité croissante entre la première électrode (3) et la deuxième électrode (4).

9. Procédé selon la revendication 7 ou 8, **caractérisé en ce que** l'étape de rupture consiste à appliquer une rampe de courant entre la première électrode (3) et la deuxième électrode (4).

10. Procédé selon la revendication 9, **caractérisé en ce que** la rampe de courant est assortie d'une limitation en tension.

11. Procédé selon l'une quelconque des revendications 7 à 10, **caractérisé en ce qu'**il comporte, entre l'étape de rupture et l'étape de dépôt de la couche de passivation, une étape de nettoyage destinée à éliminer des résidus résultant de l'étape de rupture.

12. Procédé selon l'une quelconque des revendications 7 à 11, **caractérisé en ce qu'**il comporte une étape de vérification que chaque zone fusible (9) associée à la portion (30) de la première électrode (3) d'un îlot défectueux est effectivement rompue.

**Patentansprüche**

1. Feldeffekttransistor (100, 200), umfassend:

   - ein Substrat (1);
   - eine Halbleiterstruktur (2), die auf einer Hauptseite des Substrats (1) gebildet ist, wobei die Halbleiterstruktur (2) einen Kanalbereich (7) umfasst;
   - eine erste Elektrode (3) und eine zweite Elektrode (4), zwischen denen sich der Kanalbereich (7) erstreckt, wobei die erste Elektrode (3) eine Vielzahl von Abschnitten (30) umfasst, die voneinander beabstandet sind, wobei jeder Abschnitt (30) der ersten Elektrode (3) zum Bilden eines als "Insel" bezeichneten elementaren Transistors beiträgt;
   - Anschlussbahnen (36) zum elektrischen Anschließen der Abschnitte (30) der ersten Elektrode (3) aneinander;
   - erste Sicherungsbereiche (9), die jeweils einen Abschnitt (30), der der ersten Elektrode (3) zugeordnet ist, an eine Anschlussbahn (36) anschließen;
   - wenigstens einen zweiten Sicherungsbereich, der derart gebrochen ist, dass ein Abschnitt (30), der der ersten Elektrode (3), die zu einer fehlerhaften Insel gehört, zugeordnet ist, elektrisch isoliert ist;
   - eine Passivierungsschicht, die auf den Inseln, den Anschlussbahnen (36) und den Sicherungsbereichen (9) angeordnet ist, wobei die Passivierungsschicht jeden Raum einnimmt, der durch den Bruch des genannten wenigstens einen zweiten Sicherungsbereichs (9) hergestellt ist.

2. Transistor (100, 200) gemäß Anspruch 1, **dadurch gekennzeichnet, dass** die Sicherungsbereiche (9) sich gemäß einer Längsrichtung erstrecken.

3. Transistor (100, 200) gemäß irgendeinem der Ansprüche 1 und 2, **dadurch gekennzeichnet, dass** jede Insel einen maximalen Betriebsstrom aufweist, wobei die Sicherungsbereiche (9) derart ausgelegt sind, dass sie den maximalen Betriebsstrom unterstützen.

4. Transistor (100, 200) gemäß irgendeinem der Ansprüche 1 bis 3, **dadurch gekennzeichnet, dass** die zweite Elektrode (4) ebenfalls eine Vielzahl von Abschnitten (40) umfasst, die voneinander beabstandet sind, wobei die Abschnitte (30, 40) der ersten Elektrode (3) und der zweiten Elektrode (4) derart abwechselnd voneinander beabstandet sind, um ein Muster vom Typ Schachbrett zu bilden.

5. Transistor (100, 200) gemäß irgendeinem der Ansprüche 1 bis 4, **dadurch gekennzeichnet, dass** die Sicherungsbereiche (9) aus demselben Material wie die Anschlussbahnen (36) ausgeführt sind.

6. Transistor (100, 200) gemäß irgendeinem der Ansprüche 1 bis 5, **dadurch gekennzeichnet, dass** die Sicherungsbereiche (9) aus Kupfer, aus Aluminium oder aus Wolfram sind.

7. Herstellungsverfahren eines Feldeffekttransistors (100, 200), umfassend die folgenden Schritte:

   - Bilden einer Halbleiterstruktur (2) auf einer Hauptseite eines Substrats (1), wobei die Halbleiterstruktur (2) einen Kanalbereich (7) umfasst;
   - Bilden einer ersten Elektrode (3) und einer zweiten Elektrode (4), zwischen denen sich der Kanalbereich (7) erstreckt, wobei die erste Elektrode (3) eine Vielzahl von Abschnitten (30) umfasst, die voneinander beabstandet sind, wobei jeder Abschnitt (300) der ersten Elektrode (3) zum Bilden eines als "Insel" bezeichneten elementaren Transistors beiträgt;
   - Bilden von Anschlussbahnen (36) zum elektrischen Anschließen der Abschnitte (30) der ersten Elektrode (3) aneinander;
   - Bilden der Sicherungsbereiche (9), die jeweils einem Abschnitt (30) der ersten Elektrode (3) einer Insel zugeordnet sind, wobei jeder Sicherungsbereich (9) den Abschnitt (30), der der ersten Elektrode (3) zugeordnet ist, an eine Anschlussbahn (36) anschließt und geeignet ist, derart gebrochen zu sein, dass die genannte Insel elektrisch isoliert ist, wenn sie fehlerhaft ist;
   - Brechen jedes Sicherungsbereichs (9), der dem Abschnitt (30) der ersten Elektrode (3) einer fehlerhaften Insel zugeordnet ist;
   - Aufbringen einer Passivierungsschicht auf den Inseln, den Anschlussbahnen (36) und den Sicherungsbereichen (9), wobei die Passivierungsschicht jeden Raum einnimmt, der durch den Bruch eines Sicherungsbereichs (9) hergestellt ist.

**8.** Verfahren gemäß Anspruch 7, **dadurch gekennzeichnet, dass** der Bruchschritt im Anwenden eines Stroms gebildet wird, dessen Intensität zwischen der ersten Elektrode (3) und der zweiten Elektrode (4) ansteigt.

**9.** Verfahren gemäß Anspruch 7 oder 8, **dadurch gekennzeichnet, dass** der Bruchschritt im Anwenden einer Stromrampe zwischen der ersten Elektrode (3) und der zweiten Elektrode (4) gebildet ist.

**10.** Verfahren gemäß Anspruch 9, **dadurch gekennzeichnet, dass** die Stromrampe einer Spannungsbegrenzung zugeordnet ist.

**11.** Verfahren gemäß irgendeinem der Ansprüche 7 bis 10, **dadurch gekennzeichnet, dass** sie zwischen dem Bruchschritt und dem Aufbringungsschritt der Passivierungsschicht einen Reinigungsschritt umfasst, der zum Austragen der Rückstände bestimmt ist, die aus dem Bruchschritt resultieren.

**12.** Verfahren gemäß irgendeinem der Ansprüche 7 bis 11, **dadurch gekennzeichnet, dass** es einen Überprüfungsschritt umfasst, dass jeder Sicherungsbereich (9), der dem Abschnitt (30) der ersten Elektrode (3) einer fehlerhaften Insel zugeordnet ist, tatsächlich gebrochen ist.

**Claims**

**1.** Field effect transistor (100, 200) comprising:

- a substrate (1);
- a semiconductor structure (2) formed on a main face of the substrate (1), the semiconductor structure (2) comprising a channel area (7);
- a first electrode (3) and a second electrode (4) between which extends the channel area (7), the first electrode (3) comprising a plurality of portions (30) spaced apart from each other, each portion (30) of the first electrode (3) contributing to forming an elementary transistor referred to as "island";
- connection tracks (36) for electrically connecting the portions (30) of the first electrode (3) to one another;
- first fuse areas (9) each connecting an associated portion (30) of the first electrode (3) to a connection track (36);
- at least one second fuse area broken in such a way as to electrically insulate an associated portion (30) of the first electrode (3) belonging to a defective island;
- a passivation layer arranged on the islands, the connection tracks (36) and the fuse areas (9), the passivation layer occupying each space created by the breakage of said at least one second fuse area (9).

**2.** Transistor (100, 200) according to claim 1, **characterised in that** the fuse areas (9) extend along a longitudinal direction.

**3.** Transistor (100, 200) according to any one of claims 1 and 2, **characterised in that** each island has a maximum operating current, the fuse areas (9) being dimensioned so as to withstand the maximum operating current.

**4.** Transistor (100, 200) according to any one of claims 1 to 3, **characterised in that** the second electrode (4) also comprises a plurality of portions (40) spaced apart from each other, the portions (30, 40) of the first electrode (3) and the second electrode (4) being arranged in an alternating manner to form a checker type pattern.

**5.** Transistor (100, 200) according to any one of claims 1 to 4, **characterised in that** the fuse areas (9) are made of the same material as the connection tracks (36).

**6.** Transistor (100, 200) according to any one of claims 1 to 5, **characterised in that** the fuse areas (9) are made of copper, aluminium or tungsten.

**7.** Method for manufacturing a field effect transistor (100, 200), comprising the following steps:

- forming a semiconductor structure (2) on a main face of a substrate (1), the semiconductor structure (2) comprising a channel area (7);
- forming a first electrode (3) and a second electrode (4) between which extends the channel area (7), the first electrode (3) comprising a plurality of portions (30) spaced apart from each other, each portion (30) of the first electrode (3) contributing to forming an elementary transistor referred to as "island";

- forming connection tracks (36) for electrically connecting the portions (30) of the first electrode (3) to one another;
- forming fuse areas (9) each associated with a portion (30) of the first electrode (3) of an island, each fuse area (9) connecting the associated portion (30) of the first electrode (3) to a connection track (36) and being capable of being broken in such a way as to electrically insulate said island if it is defective;
- breaking each fuse area (9) associated with the portion (30) of the first electrode (3) of a defective island;
- depositing a passivation layer on the islands, the connection tracks (36) and the fuse areas (9), the passivation layer occupying each space created by the breakage of a fuse area (9).

8. Method according to claim 7, **characterised in that** the breakage step consists in applying a current of increasing intensity between the first electrode (3) and the second electrode (4).

9. Method according to claim 7 or 8, **characterised in that** the breakage step consists in applying a current ramp between the first electrode (3) and the second electrode (4).

10. Method according to claim 9, **characterised in that** the current ramp is combined with a voltage limitation.

11. Method according to any one of claims 7 to 10, **characterised in that** it comprises, between the breakage step and the step of deposition of the passivation layer, a cleaning step intended to eliminate residues resulting from the breakage step.

12. Method according to any one of claims 7 to 11, **characterised in that** it comprises a step of verifying that each fuse area (9) associated with the portion (30) of the first electrode (3) of a defective island is actually broken.

**Fig. 1A**

**Fig. 1B**

**Fig. 1C**

**Fig. 2**

**Fig. 3**

**Fig. 4**

Fig. 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

•   EP 2690657 A

**Littérature non-brevet citée dans la description**

•   **P.G. SLADE et al.** Electrical Breakdown in Atmospheric Air Between Closely Spaced (0.2$\mu$m-40$\mu$m) Electrical Contacts. *IEEE Transactions On Components And Packaging Technologies,* 2002, vol. 25 (3